Europäisches Patentamt

(19) **European Patent Office** (11) Numéro de publication: **0 032 068**
**B1**
Office européen des brevets

(12) FASCICULE DE BREVET EUROPEEN

(45) Date de publication du fascicule du brevet: (51) Int. Cl.³: **H 01 L 21/60,** H 01 L 25/04,
**25.01.84** H 01 L 23/56

(21) Numéro de dépôt: **80401600.4**

(22) Date de dépôt: **07.11.80**

(54) Diode tripôle et son montage en boîtier unique avec un composant semiconducteur principal.

(30) Priorité: **07.12.79 FR 7930125** (73) Titulaire: **LE SILICIUM SEMICONDUCTEUR SSC,**
**101, Boulevard Murat, F-75016 Paris (FR)**

(43) Date de publication de la demande:
**15.07.81 Bulletin 81/28** (72) Inventeur: **Bacuvier, Pierre, "THOMSON-CSF" SCPI**
**- 173, bld Haussmann, F-75360 Paris Cedex 08 (FR)**

(45) Mention de la délivrance du brevet:
**25.01.84 Bulletin 84/4** (74) Mandataire: **de Beaumont, Michel et al, THOMSON-CSF**
**SCPI 173, Bld Haussmann, F-75379 Paris Cedex 08 (FR)**

(84) Etats contractants désignés:
**DE FR GB IT NL**

(56) Documents cités:
**CH - A - 510 346**
**DE - A - 2 359 787**
**FR - A - 1 567 695**
**US - A - 3 975 758**

ACTORUM AG

**Diode tripôle et son montage en boîtier unique avec un composant semiconducteur principal**

La présente invention concerne une configuration particulière de diode tripôle.

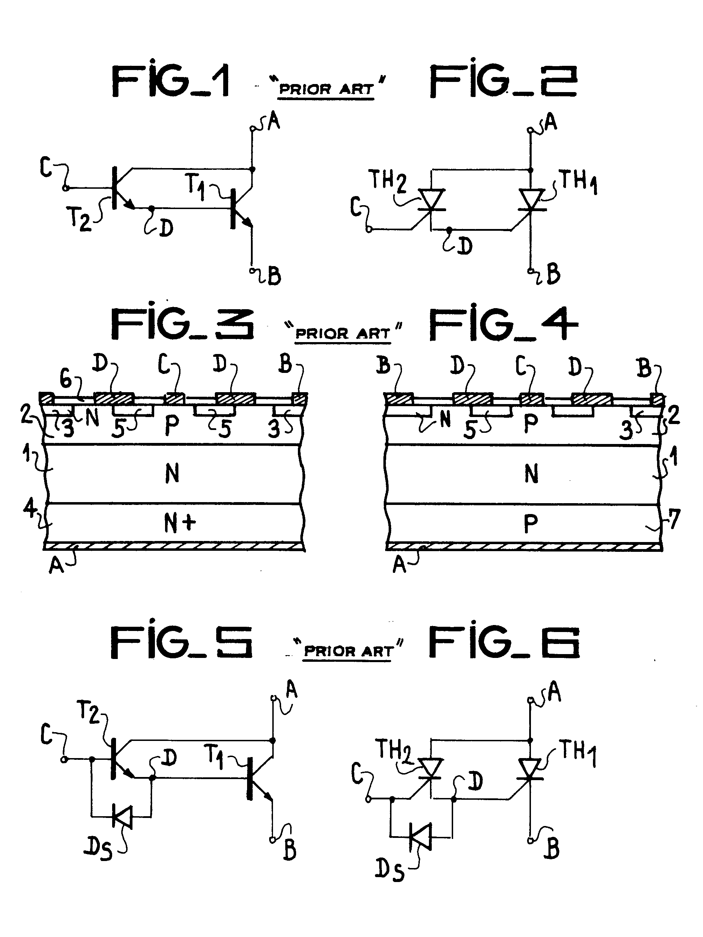

La diode selon la présente invention simplifie notamment l'association d'un circuit du type diode de déstockage avec des montages de transistors à amplification intégrée de type Darlington ou de thyristors de type à amplification de gâchette. Ainsi, on va d'abord rappeler ci-dessous en relation avec les figures 1 à 6 la nature et la structure de ces circuits particuliers.

La figure 1 représente un montage de transistors de type Darlington. Ce montage comprend un premier transistor ou transistor de puissance $T_1$ associé à un transistor de commande ou transistor pilote $T_2$. Les collecteurs des transistors $T_1$ et $T_2$ sont interconnectés et l'émetteur du transistor $T_2$ est relié à la base du transistor $T_1$. Ce montage comprend trois bornes: des bornes principales A et B auxquelles est appliqué le signal à commuter et une borne de commande C. La borne A correspond au collecteur des transistors $T_1$ et $T_2$, la borne B à l'émetteur du transistor $T_1$ et la borne C à la base du transistor $T_2$. Pour l'utilisateur, ce montage Darlington se présente comme un transistor particulièrement sensible.

La figure 2 représente un montage de thyristors à amplification de gâchette. Ce montage comprend un thyristor principal ou thyristor de puissance $Th_1$ et un thyristor auxiliaire $Th_2$. Les anodes de ces thyristors sont inerconnectées et la cathode du thyristor $Th_2$ est connectée à la gâchette du thyristor $Th_1$. Ce montage comprend trois bornes: deux bornes principales A et B auxquelles est appliqué le signal à commuter et une borne de commande C. La borne A correspond aux anodes des thyristors $Th_1$ et $Th_2$, la borne B correspond à la cathode du thyristor $Th_1$ et la borne C correspond à la borne de gâchette du thyristor $Th_2$. Ce circuit se comporte pour un utilisateur comme un thyristor unique particulièrement sensible et robuste à la fermeture.

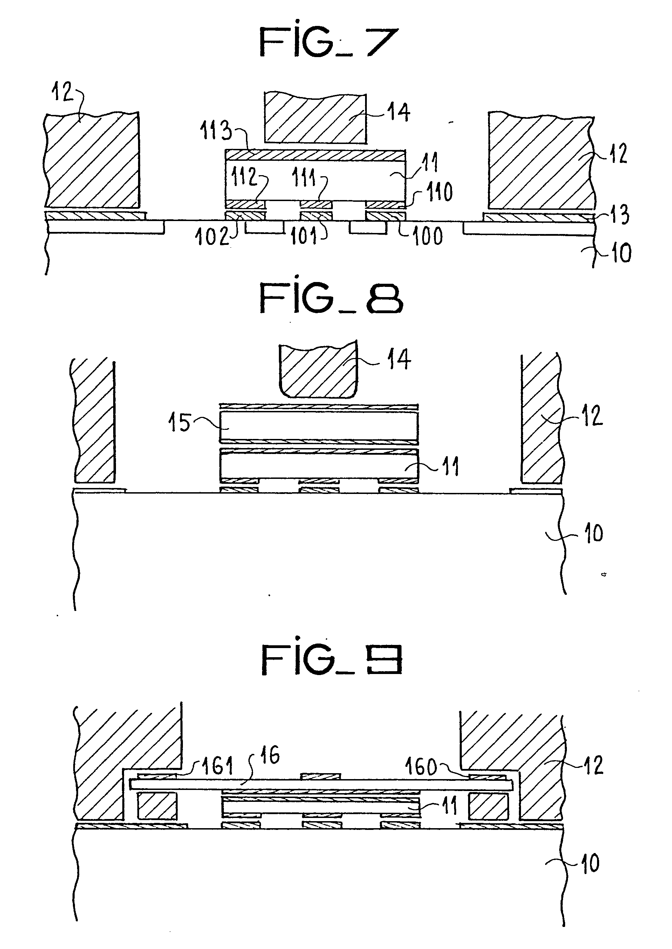

On voit ainsi une grande analogie entre les montages de transistor de type Darlington et les montages de thyristor à amplification de gâchette. Dans les deux cas, l'étage d'amplification constitué par le transistor $T_2$ ou le thyristor $Th_2$, respectivement, pourrait être un étage multiple comprenant plusieurs transistors ou plusieurs thyristors. Dans les figures 1 et 2, on désignera d'ailleurs par la même référence B, la borne de commande du composant principal. L'analogie entre les circuits des figures 1 et 2 se poursuit si l'on considère leur réalisation sous forme intégrée classique telle qu'elle est illustrée dans les figures 3 et 4.

La figure 3 représente une structure de transistors en montage Darlington. Le transistor principal ou transistor de puissance $T_1$ n'est représenté que de façon partielle et comprend une couche de collecteur 1 de type N, une couche de base 2 de type P et une couche d'émetteur 3 de type N. L'émetteur est revêtu d'une métallisation d'émetteur désignée par la référence B et la couche de collecteur est revêtu d'une metallisation de collecteur désignée par la référence A, avec interposition d'une couche surdopée 4 de type $N^+$. La structure amplificatrice est réalisée en ajoutant une couche 5 de type N (annulaire comme la couche 3 dans l'exemple représenté) qui correspond à la zone d'émetteur du transistor pilote $T_2$. Une métallisation centrale C correspond à la borne de commande illustrée en figure 1 et une métallisation D reliant la couche d'émetteur du transistor pilote à la couche de base du transistor principal correspond à la borne D de la figure 1. La couche 6 apparaissant entre les métallisations de la face principale représente schématiquement une couche d'un matériau de passivation.

La figure 3 représente de façon très schématique une structure de thyristor à amplification de gâchette mettant en œuvre le circuit de la figure 2. Cette figure ne sera pas décrite en détail. On notera seulement sa grande analogie avec la figure 3. La différence essentielle résidant dans le fait que la couche 4 de type $N^+$ de la figure 3 est remplacée par une couche 7 de type P. On notera néanmoins qu'il faut entendre par le terme thyristor, toute structure à 4 couches de type NPNP, c'est-à-dire aussi bien les structures classiques telles qu'illustrées en figure 4 que celles inhérentes aux thyristors ouvrables par la gâchette ou à ouverture assistée par la gâchette. Les thyristors peuvent aussi avoir des structures asymétriques de type $NPNN^+P$ et des structures faisant appel à diverses formes d'interdigitation tant en ce qui concerne l'étage de puissance que les étages amplificateurs. Les structures à quatre couches peuvent aussi être bidirectionnelles (type Triac).

Le montage de structures de puissance telles que celles des figures 3 et 4 fait souvent appel à une technologie du type à contact pressé sur la pastille de silicium, cette dernière pouvant être ou non préalablement alliée sur une contre-électrode de molybdène ou de tungstène par exemple. Pour réaliser la mise sous pression des contacts, deux approches sont couramment utilisées. L'une met en œuvre un boîtier dit «à vis» et intégrant le système de mise sous pression à l'aide de ressorts internes (rondelles dites de Belleville). L'autre utilise une technique en boîtier plat légèrement déformable, la pression sur le composant étant alors appliquée directement par l'utilisateur lors de l'insertion du composant dans un convecteur (ces boîtiers sont couramment appelés boîtiers pressés double face). Dans chacun des cas, il est également possible de prévoir la liaison électrique de la commande par mise sous pression du contact d'électrode de commande (C) avec une contre-électrode accessible électriquement par l'utilisateur. Quel que soit le type de boîtier et de composant, la configuration qualitative des prises de contact sur la face supérieure est identique.

Après ces rappels sur la nature et la structure des circuits de puissance particuliers constitués par les montages Darlington ou de thyristors à amplification de gâchette, on va maintenant donner un exemple de composant auxiliaire que les utilisateurs cherchent souvent à utiliser en relation avec ces composants de puissance particuliers. Les structures, telles que représentées en figures 1 et 2, ne conduisent pas à une configuration électrique optimale pour le comportement dynamique global de la structure intégrée et plus spécifiquement lors de l'ouverture électrique. Les origines de cette limitation sont, comme cela est bien connu, essentiellement associées au fait qu'il est difficile d'assister électriquement l'ouverture du composant à partir de l'électrode de commande C accessible à l'utilisateur d'une structure amplificatrice classique. En effet, dans le cas des polarités de couches représentées dans les figures 3 et 4, il est utile pour faciliter l'ouverture du composant de pouvoir appliquer un potentiel négatif sur la métallisation D de l'étage de puissance de façon, par exemple, à extraire électriquement par cette électrode une partie des charges induites dans l'étage de puissance par la mise en conduction précédente. En effet, dans le cas d'une structure intégrée telle que représentée en figures 3 et 4, la jonction entre les couches 5 et 2 de l'étage amplificateur pilote se bloque rapidement et s'oppose à l'extraction d'un courant négatif sur l'électrode de commande de l'étage de puissance de la structure intégrée, ce qui retarde considérablement les possibilités dynamiques d'ouverture de ce dernier.

Pour résoudre cette difficulté, il est connu, comme le représentent schématiquement les figures 5 et 6, qu'il est souhaitable de prévoir une diode de dérivation également appelée diode de récupération ou diode de déstockage entre les bornes D et C définies précédemment.

Dans l'art antérieur, pour réaliser le montage du circuit auxiliaire constitué par la diode de déstockage avec le composant principal, constitué d'un transistor de type Darlington ou d'un thyristor à amplification de gâchette, trois approches ont été utilisées.

La première approche consiste à intégrer la diode de déstockage dans la pastille de silicium du composant principal. Cette première approche paraît la plus séduisante plus particulièrement dans le cas de dispositifs de petite puissance pour lesquels le coût de réalisation constitue l'un des objectifs industriels principaux. Cette approche présente néanmoins de nombreux inconvénients électriques en raison d'une part de la présence d'éléments de couplage parasites inhérents à l'intégration et d'autre part de l'absense de souplesse pour ajuster les caractéristiques électriques de la diode de déstockage aux besoins de l'utilisateur. Cette limitation est particulièrement ressentie dans le cas des dispositifs de forte puissance.

La deuxième approche consiste à rendre accessible à l'extérieur du boîtier du composant de puissance les bornes C et D et à câbler la diode de destockage à l'extérieur du boîtier. Cette deuxième approche nécessite la prévision de nouveaux boîtiers spécifiques, ce qui constitue une difficulté industrielle non négligeable pour le fabricant de composants et d'autre part impose à l'utilisateur des opérations de câblage électrique supplémentaires.

La troisième approche consiste à rendre accessible à l'intérieur du boîtier du composant de puissance la borne D et à insérer la diode de déstockage dans le boîtier et à l'y câbler de façon interne. Cette troisième approche conduit à des opérations technologiques délicates de câblage à l'intérieur d'un boîtier et nécessite d'autre part l'emploi de boîtiers surdimensionnés pour permettre de loger la diode de déstockage. Il existe ainsi une surface d'insertion perdue pour l'étage de puissance, c'est-à-dire pour les performances du composant. En effet, le boîtier constitue l'un des éléments de coût non négligeables pour un composant de puissance.

Une autre approche décrite dans le brevet américain 3 975 758 prévoit un montage en boîtier unique d'un composant semiconducteur principal de commutation de puissance du type Darlington ou thyristor à amplification de gâchette et d'un composant auxi-liaire assurant notamment la fonction de diode de déstockage comprenant des moyens de pression pour appliquer les unes contre les autres des métallisations en regard des faces avant des composants auxiliaire et principal.

L'objet de la présente invention est de prévoir une nouvelle configuration de diode. Cette diode peut constituer une diode de déstockage assemblable par pression avec un composant semiconducteur principal de commutation de puissance.

La diode selon l'invention comprend sous forme monolithique: un substrat d'un premier type de conductivité; sur la face arrière du substrat: une couche uniforme du même type de conductivité et à fort niveau de dopage, revêtue d'une métallisation; sur la face avant du substrat: une première couche localisée du deuxième type de conductivité à fort niveau de dopage et une deuxième couche localisée du premier type de conductivité à fort niveau de dopage, les surfaces occupées par chacune de ces deux couches étant sensiblement complémentaires, des première et seconde métallisations étant respectivement disposées sur les première et seconde couches.

Dans un montage avec un composant principal du type Darlington ou thyristor à amplification de gâchette, les première et deuxième métallisations viennent contacter électriquement des métallisations en regard de la face avant du composant principal; d'où il résulte que l'on obtient entre la métallisation de face arrière et la seconde métallisation de face avant, une première résistance et entre les première et seconde métallisations de face avant, une seconde résistance en série avec une diode.

La première couche localisée peut être disposée à la périphérie de la face avant, la seconde couche localisée étant disposée de façon centrale. La face arrière du substrat peut être évidée avant formation de la couche fortement dopée sur cette face, sensiblement en regard de la deuxième couche localisée sur la face avant, d'où il résulte une diminution de la première résistance, la profondeur de l'évidement étant choisie en fonction de la valeur souhaitée de cette première résistance. La zone séparant les première et deuxième couches localisées peut être sillonnée, d'où il résulte que l'on accroît la valeur de la seconde résistance, le dimensionnement du sillon étant choisi pour régler la valeur de cette seconde résistance. La première métallisation de face avant peut assurer des courts-circuits entre la première couche localisée et une zone du type de conductivité du substrat, d'où il résulte que l'on introduit une résistance en parallèle sur ladite diode.

Des éléments conducteurs mous tels que des billes ou une poudre à gros grains peuvent être solidaires de l'une au moins des faces en regard des deux composants et assurer le contact entre les métallisations en regard. Des éléments élastiques conducteurs tels que des ressorts annulaires peuvent être intercalés entre certaines au moins des métallisations en regard. Des éléments conducteurs intercalaires, tels que des grilles métalliques peuvent être positionnés sur des métallisations du composant principal et viennent contacter les métallisations du composant auxiliaire, notamment quand les métallisations en cause sont fortement digitées.

Quand la face avant du composant de commutation de puissance comprend une métallisation principale occupant la plus grande partie de sa surface et sur laquelle vient s'appuyer une contre-électrode principale, les moyens de pression peuvent prendre appui sur cette contre-électrode principale ou directement sur le boîtier du composant principal. Dans ce dernier cas, les moyens de pression preuvent être constitués d'un doigt métallique, conducteur et élastique, fixé à une partie isolée du boîtier et relié à une borne externe au boîtier, et pressant sur la face arrière du composant auxiliaire, éventuellement par l'intermédiaire d'un clou conducteur coulissant librement dans une coquille de guidage isolante.

On notera parmi les avantages de la présente invention les points suivants: le montage est particulièrement simple et fiable. Il est particulièrement économique du fait qu'il permet d'insérer le circuit auxiliaire dans le boîtier généralement utilisé pour le composant principal en ne modifiant pratiquement pas ce boîtier. Il présente un caractère de versatilité étant donné que, en fonction des besoins de l'utilisateur, des circuits auxiliaires distincts peuvent être associés à un même composant principal.

Ces objets, caractéristiques et avantages ainsi que d'autres de la présente invention seront exposés plus en détail dans la description suivante de modes de réalisation particuliers faite en relation avec les figures jointes parmi lesquelles:

les figures 1 à 6, destinées à illustrer l'état de la technique, ont été décrites précédemment;

les figures 7 à 9 représentent schématiquement et à titre d'exemple, divers modes de montage de composants auxiliaires avec un composant principal;

les figures 10A et 10B représentent en coupe et en vue de dessus, un mode de réalisation de diode tripôle selon l'invention;

la figure 11 représente un circuit équivalent à une diode tripôle selon l'invention;

la figure 12 représente le circuit équivalent d'une diode tripôle selon l'invention et d'un montage de type Darlington;

les figures 13 à 15 représentent des variantes de diodes tripôles selon la présente invention;

la figure 16 illustre un détail de la structure de montage d'une diode selon la présente invention;

les figures 17 à 20 représentent de façon détaillée quoique schématique divers modes de réalisation de montages d'une diode selon la présente invention.

Dans les diverses figures, on notera que les diverses couches, structures et composants n'ont pas été tracés à l'échelle entre eux, ni d'une figure à l'autre, les dimensions ayant seulement été choisies, conformément à l'usage, pour faciliter la lecture et la compréhension. D'autre part, dans ces figures, de mêmes références désignent des composants, éléments, ou couches identiques ou analogues.

La figure 7 est destinée à illustrer un mode de montage de la diode selon la présente invention. Etant donné un composant semiconducteur principal 10 de commutation du type Darlington ou thyristor à amplification de gâchette dont on a représenté uniquement à titre d'exemple certaines jonctions mais comprenant éventuellement d'autres jonctions ou des jonctions d'autres formes, l'une des caractéristiques de la présente invention réside dans le fait de monter par application d'une pression sur ce composant principal 10, un composant auxiliaire 11 du type diode de déstockage. Ce composant auxiliaire 11 comprend des métallisations 110, 111 et 112 venant presser directement ou non contre des métallisations correspondantes 100, 101 et 102 du composant principal. La référence 12 désigne une contre-électrode, en contact électrique avec une électrode principale 13 du composant principale. La métallisation 101 du composant principal correspond à la borne C, les métallisations 100 et 102 sont reliées et forment un anneau correspondant à la métallisation D et la métallisation 13 correspond à la métallisation B. Un moyen 14 sert à transmettre la force de pression appliquant le composant 11 contre le composant 10. Ce moyen 14 peut être une contre-électrode venant en contact avec une métallisation supérieure 113 du composant auxiliaire.

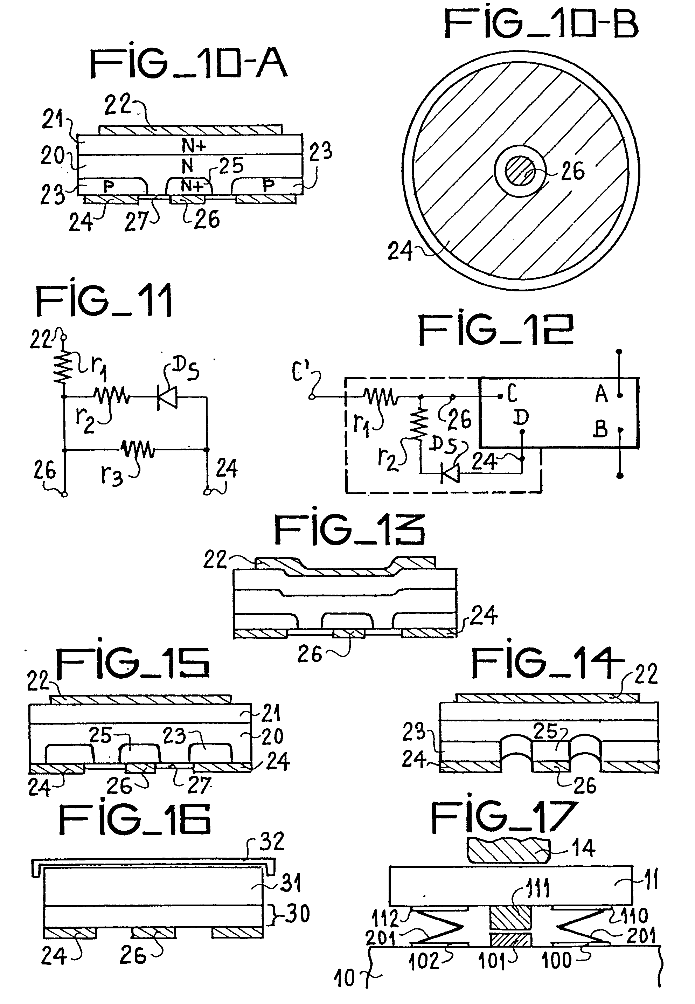

Les figures 8 et 9 sont destinées à mieux faire comprendre l'aspect général de la présente invention qui est susceptible de nombreuses variantes. Par exemple, comme le représente la figure 8, un second composant auxiliaire 15 peut être appliqué au-dessus du composant 11 par le même moyen de pression 14. Comme le représente la figure 9, le second composant auxiliaire, désigné dans cette figure par la référence 16, peut présenter des métallisations 160 et 161 venant en contact avec la contre-électrode principale 12. De même, le composant unique 11, aurait pu venir en contact électrique partiel avec cette borne principale 12.

On voit ressortir les principaux avantages de la présente invention dans son application à l'association d'une diode de déstockage à un composant principal, à savoir:

— utilisation possible des boîtiers classiques à montage pressé sans aucune modification fondamentale de ces boîtiers,

— aucune surface supplémentaire nécessaire pour l'insertion d'éléments auxiliaires,

— possibilité de modifier l'élément auxiliaire pour l'adapter à un besoin électrique spécifié sans remettre en cause la conception du composant de puissance et son boîtier,

— possibilité de monter le composant principal avec ou sans composant auxiliaire,

— grande souplesse possible pour définir avec l'utilisateur de façon précise, les caractéristiques de l'élément auxiliaire à associer pour un besoin électrique donné, ce qui favorise l'optimisation de réalisation de ce composant auxiliaire,

— aucun coût supplémentaire de montage,

— meilleur rendement électrique de la fabrication,

— absence des effets parasites internes dûs à l'intégration éventuelle du circuit auxiliaire sur le composant principal.

Les figures 10A et 10B représentent schématiquement, respectivement en coupe et en vue de dessous, un mode de réalisation d'une diode selon l'invention pouvant servir de composant auxiliaire 11 dans le cas de la figure 7. La diode se présente sous forme d'un substrat semiconducteur 20 d'un premier type de conductivité, par exemple de type N assez fortement dopé. Sur la face arrière du substrat est formée une couche 21 de même type de conductivité très fortement dopée et une métallisation 22. Sur la face avant du substrat sont formées une zone 23 de type P très fortement dopée et une métallisation 24 et, sensiblement dans la zone non occupée par la couche 23, une couche 25 très fortement dopée de type N revêtue d'une métallisation 26. Il est également représenté dans la figure une couche 27 d'un agent de passivation pour passiver les affleurements de jonction. Il sera éventuellement prévu également de passiver les affleurements de jonction latéraux de la diode. On obtient ainsi une diode tripôle comprenant une métallisation de face arrière 22, et des première et seconde métallisations de face avant 24 et 26. La couche 23 peut avoir une forme annulaire mais ceci ne doit pas être considéré comme restrictif et la forme de cette couche et de la métallisation 24 sera propre à s'adapter au montage souhaité, par exemple à la métallisation superficielle du composant Darlington ou thyristor à amplification de gâchette tels que représentés en figures 3 et 4, la métallisation 24 venant en contact électrique sur la métallisation D, la métallisation 26 sur la métallisation C.

La figure 11 représente un schéma équivalent de la diode tripôle de la figure 10A. Entre les métallisations de face avant 24 et 26, on trouve en série une diode $D_S$ et une résistance de faible valeur $r_2$. Entre la métallisation 26 et la métallisation 22 de face arrière, on trouve une résistance de faible valeur $r_1$. Une résistance $r_3$ peut être présente ou non entre les métallisations 24 et 26. Elle l'est notamment dans le cas d'une configuration telle que celle de la figure 15.

La figure 12 représente le schéma correspondant à l'association de la diode de déstockage de la figure 10 et d'un composant de puissance tel qu'un Darlington ou un thyristor à amplification de gâchette représentés en figures 1 à 4. De mêmes références désignent des mêmes éléments.

Il peut être souhaitable pour des applications particulières de contrôler de façon précise les valeurs des résistances $r_1$, $r_2$ et $r_3$. Indépendamment du choix de dimensionnement du composant et du choix des niveaux de dopage de ses différentes couches, on peut recourir à des techniques telles que représentées en figure 13 et 14. En figure 13, le substrat a été évidé localement sur sa face arrière, par exemple par attaque chimique, avant d'effectuer la diffusion pour former la couche 21. On obtient ainsi une diminution de l'épaisseur restante du substrat entre la métallisation 26 et la métallisation 22 et conséquemment une diminution de la valeur de la résistance $r_1$. En figure 14, on a représenté un sillonnage à la limite entre les couches de type opposé 23 et 25. On peut ainsi faire croître la valeur de la résistance $r_2$. Mais bien

entendu, de nombreux autres procédés connus dans la technique peuvent être utilisés pour ajuster les valeurs de ces résistances. On notera plus particulièrement que la résistance $r_1$ peut être de très faible valeur du fait que la diode de déstockage utilisée dans l'application concernée ne doit jamais supporter des tensions inverses élevées. La résistivité de son substrat 20 peut donc être très faible, c'est-à-dire son niveau de dopage élevé.

A titre de variante de réalisation de la diode, la figure 15, dans laquelle de mêmes références désignent des mêmes couches qu'en figure 10A, représente schématiquement la mise en court-circuit des couches 20 et 23 par la métallisation 24. Ceci fournit dans le schéma équivalent de la figure 11, une résistance $r_3$ en parallèle sur la diode $D_3$. Cette mise en court-circuit peut être également assurée par les trous de court-circuit (zones non diffusées) traversant la couche 23.

Comme le représente la figure 16, de façon classique, la diode de déstockage 30 peut être alliée ou soudée à une petite contre-électrode métallique 31, par exemple en molybdène ou en tungstène pour en renforcer les propriétés mécaniques. De même, les contacts électriques 24 et 26 adjacents à l'élément de puissance peuvent être adaptés pour faciliter la transmission électrique et mécanique, par exemple au moyen de matériaux ductiles relativement mous tels que l'argent. D'autre part, des billes de matériaux mous peuvent être déposées sur les métallisations 24 et 26 pour favoriser la prise de contact mécanique avec l'élément principal sous-jacent. De tels billes ou grains en relief pourraient être déposés de façon complémentaire sur les métallisations correspondantes du composant de puissance. On pourra également disposer sur la face arrière du composant auxiliaire une intercalaire indépendante 32 en un matériau ductile assez mou pour favoriser le contact avec l'élément presseur. De même, les techniques utilisées fréquemment pour les contacts ramifiés de façon à faciliter leur mise en pression peuvent être mises à profit dans le cadre de la présente invention (contact à deux niveaux, grille intercalaire...). On utilisera avec profit des grilles métalliques intercalaires quand les métallisations sur lesquelles s'appuient le composant auxiliaire sont fortement ramifiées ou interdigitées. Pour garantir un contact mécanique et électrique entre les contacts 24 ou 26 et l'élément de puissance, il peut être fait appel à une liaison élastique intermédiaire en lieu et place des contacts mous précédemment évoqués. Par exemple, un ressort annulaire plat 201 pourrait être inséré entre le contact 24 et le contact associé de l'élément de puissance (figure 17).

On va maintenant décrire divers modes de réalisation de moyens de montage mécanique sous pression d'une diode selon l'invention contre un composant principal du type Darlington ou thyristor à amplification de gâchette.

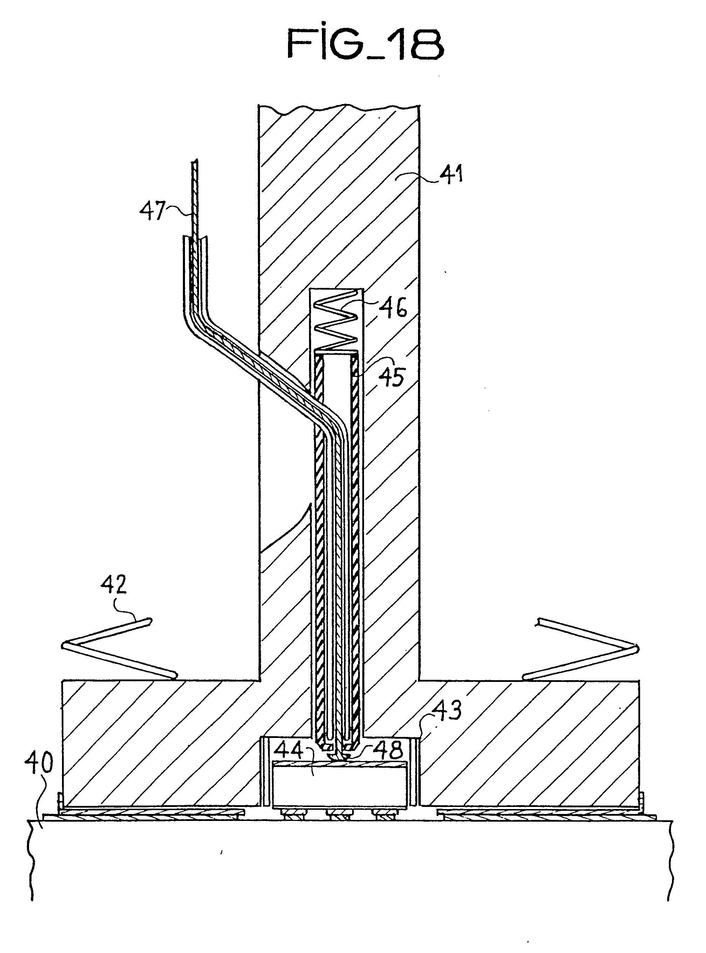

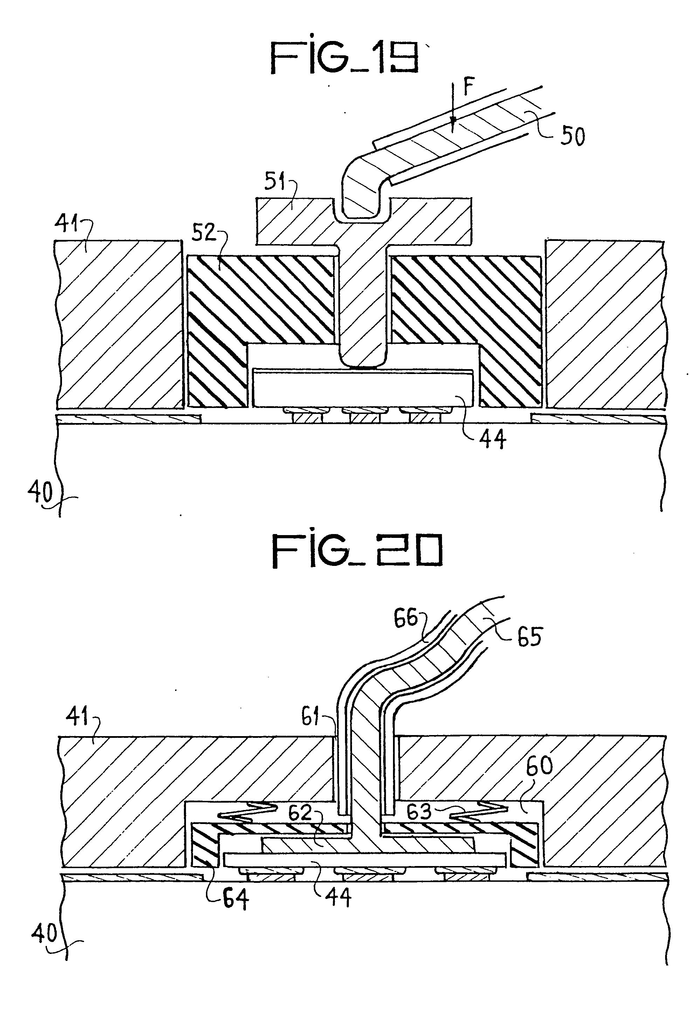

La figure 18 illustre le cas où le composant principal 40 est monté dans un boîtier dit à vis dans lequel la pression sur une contre-électrode 41 est produite par des ressorts internes au boîtier. Ces moyens de pression sont figurés schématiquement par des rondelles de type Belleville 42. Le composant auxiliaire 44 est alors placé dans un évidement de la contre-électrode 41 dont il est isolé par un anneau 43, par exemple en céramique. Un évidement allongé dans la contre-électrode 41 est occupé par un anneau de céramique ou autre matériau isolant rigide 45 pressé vers le bas par un ressort 46. Un fil conducteur isolé 47 passe à l'intérieur du cylindre isolant 45 et vient presser par son extrémité évasée 48 contre la métallisation supérieure du composant auxiliaire. On notera que, dans ce mode de réalisation, à part la prévision de l'évidement isolé par la bague 43 à la base de la contre-électrode 41, dans lequel est placé le composant auxiliaire 44, le montage est identique au cas où le composant auxiliaire n'est pas prévu.

Les figures 19 et 20 illustrent des modes de montage dans le cas où le boîtier du composant principal est du type à pression double face générée par l'utilisateur lors de l'insertion dans un convecteur. Dans le cas de la figure 19, la pression sur le composant auxiliaire est exercée par un doigt d'électrode 50, solidaire du boîtier isolant du composant principal. Dans le cas de la figure 20, la pression sur le composant auxiliaire est exercée en prenant appui sur la contre-électrode principale 41.

En figure 19, on retrouve le composant principal 40, la contre-électrode 41, qui est cette fois-ci de forme annulaire et présente un évidement central, et le composant auxiliaire 44. Un doigt élastique et conducteur 50 solidaire de la partie isolante du boîtier et d'une borne externe provoque une force de pression vers le bas selon la direction de la flèche F. Ce doigt presseur 50 appuie sur le composant auxiliaire 44 par l'intermédiaire d'un clou conducteur 51. Le clou conducteur coulisse par exemple dans une coquille isolante 52.

En figure 20, on retrouve encore le composant principal 40, la contre-électrode 41 et le composant auxiliaire 44. La contre-électrode 41 comprend un évidement partiel 60 et un trou axial 61 débouchant dans cet évidement partiel 60. Un contre-électrode 62 vient prendre appui contre la face arrière du composant auxiliaire contre lequel elle est pressée par des moyens de pression, tels que des ressorts 63 prenant appui contre la face interne de la contre-électrode principale 41, des moyens isolants tels qu'une coquille en céramique 64 étant interposés pour assurer l'isolement entre la face arrière du composant auxiliaire et la contre-électrode principale. Un fil ou doigt 65 est en contact ou en liaison directe avec la contre-électrode 62 et assure une connexion vers une borne extérieure disposée dans le boîtier dans une zone isolante de celui-ci. Le fil ou doigt 65 est muni de préférence d'un isolement 66.

Il est à noter que les figures 18 à 20 représentent uniquement des modes de réalisation particuliers de montage. L'homme de l'art pourra par exemple combiner simplement les figures 18 à 20 pour réaliser un ensemble dans le cas d'un boîtier à vis dans lequel le ressort 46 est remplacé par des moyens tels que le ressort 63 et la coquille isolante 64 de la figure 20.

Pour aider à mieux faire comprendre certains aspects pratiques de la présente invention, on peut noter que, dans le cas d'un montage de type Darlington, le composant principal peut avoir un diamètre de l'ordre de 18 à 25 mm alors que la diode de déstockage a un diamètre de l'ordre de 5 à 10 mm. Dans le cas d'un montage du type thyristor à amplification de gâchette, ce composant peut avoir un diamètre de l'ordre de 18 à 75 mm tandis que la diode de déstockage a un diamètre de l'ordre de 2 à 5 mm.

## Revendications

1. Diode semiconductrice tripôle comprenant sous forme monolithique:
— un substrat (20) d'un premier type de conductivité,
— sur la face avant du substrat: une première couche localisée (23) du deuxième type de conductivité à fort niveau de dopage et une deuxième couche localisée (25) du premier type de conductivité à fort niveau de dopage, les surfaces occupées par chacune de ces deux couches étant sensiblement complémentaires, des première (24) et seconde (26) métallisations étant respectivement disposées sur les première et seconde couches, caractérisée en ce qu'elle comprend en outre sur la face arrière du substrat: une couche (21) uniforme du même type de conductivité et à fort niveau de dopage, revêtue d'une métallisation (22),
d'où il résulte que l'on obtient entre la métallisation de face arrière et la seconde métallisation de face avant, une première résistance et entre les première et seconde métallisations de face avant, une seconde résistance en série avec une diode.

2. Diode selon la revendication 1, caractérisée en ce que la première couche localisée (23) est disposée à la périphérie de la face avant, la seconde couche localisée (25) étant disposée de façon centrale.

3. Diode selon l'une des revendications 1 ou 2, caractérisée en ce que la face arrière du substrat est évidée (Fig. 13) avant formation de la couche fortement dopée sur cette face, sensiblement en regard de la deuxième couche localisée sur la face avant, d'où il résulte une diminution de ladite première résistance, la profondeur de l'évidement étant choisie en fonction de la valeur souhaitée de cette première résistance.

4. Diode selon l'une quelconque des revendications 1 à 3, caractérisée en ce que la zone séparant les première et deuxième couches localisées est sillonnée (Fig. 14), d'où il résulte que l'on accroît la valeur de la seconde résistance, le dimensionnement du sillon étant choisi pour régler la valeur de cette seconde résistance.

5. Diode selon l'une quelconque des revendications 1 à 4, caractérisée en ce que la première métallisation (24) de face avant assure des courts-circuits entre la première couche localisée et une zone du type de conductivité du substrat (Fig. 15), d'où il résulte que l'on introduit une résistance en parallèle sur ladite diode.

6. Montage en boîtier unique d'un composant semiconducteur principal de commutation de puissance (10, 40) du type Darlington ou thyristor à amplification de gâchette et d'un composant auxiliaire (11, 14) assurant notamment la fonction de diode de déstockage, comprenant des moyens de pression pour appliquer les unes contre les autres des métallisations en regard des faces avant des composants auxiliaire et principal, caractérisé en ce que ledit composant auxiliaire est une diode tripôle selon l'une des revendications 1 à 5.

7. Montage selon la revendication 6, caractérisé en ce que des éléments conducteurs mous tels que des billes ou une poudre à gros grains sont solidaires de l'une au moins des faces en regard des deux composants et assurent le contact entre les métallisations en regard.

8. Montage selon la revendication 6, caractérisé en ce que des éléments élastiques conducteurs tels que des ressorts annulaires (201) sont intercalés entre certaines au moins des métallisations en regard.

9. Montage selon la revendication 6, caractérisé en ce que des éléments conducteurs intercalaires sont positionnés sur des métallisations du composant principal et viennent contacter des métallisations du composant auxiliaire.

10. Montage selon la revendication 6, dans lequel la face avant du composant de commutation de puissance comprend une métallisation principale occupant la plus grande partie de sa surface et sur laquelle vient s'appuyer une contre-électrode principale, caractérisé en ce que les moyens de pression prennent appui sur ladite contre-électrode principale.

11. Montage selon la revendication 6, caractérisé en ce que les moyens de pression prennent appui sur le boîtier du composant principal.

12. Montage selon la revendication 11, caractérisé en ce que les moyens de pression sont constitués d'un doigt métallique, conducteur et élastique, fixé à une partie isolée du boîtier et relié à une borne externe au boîtier, et pressant sur la face arrière du composant auxiliaire.

13. Montage selon la revendication 12, caractérisé en ce que le doigt métallique presse sur le composant auxiliaire par l'intermédiaire d'un clou conducteur coulissant librement dans une coquille de guidage isolante.

**Patentansprüche**

1. Dreipolige Halbleiterdiode, die in monolithischer Form enthält:
— ein Substrat (20) eines ersten Leitungstyps,
— auf der Vorderseite des Substrats: eine erste lokalisierte Schicht (23) des zweiten Leitungstyps und mit hohem Dotierungsniveau sowie eine zweite lokalisierte Schicht (25) des ersten Leitungstyps und mit hohem Dotierungsniveau, wobei die von jeder dieser beiden Schichten eingenommenen Oberflächen im wesentlichen komplementär sind, wobei eine erste Metallisierung (24) auf der ersten und eine zweite Metallisierung (26) auf der zweiten Schicht angeordnet ist,
dadurch gekennzeichnet, dass sie ferner auf der Rückseite des Substrats enthält: eine gleichförmige Schicht (21) desselben Leitungstyps und mit hohem Dotierungsniveau, welche durch eine Metallisierung (22) bedeckt ist,
woraus sich ergibt, dass zwischen der Metallisierung der Rückseite und der zweiten Metallisierung der Vorderseite ein erster Widerstand und zwischen der ersten und der zweiten Metallisierung der Vorderseite ein zweiter Widerstand in Reihe mit einer Diode gebildet wird.

2. Diode nach Anspruch 1, dadurch gekennzeichnet, dass die erste lokalisierte Schicht (23) am Umfang der Vorderseite angeordnet ist, während die zweite lokalisierte Schicht (25) zentral angeordnet ist.

3. Diode nach Anspruch 1 oder 2, dadurch gekennzeichnet, dass die Rückseite des Substrats von der Bildung der stark dotierten Schicht auf dieser Fläche mit einer Ausnehmung versehen wird (Fig. 13), die im wesentlichen gegenüber der zweiten lokalisierten Schicht auf der Vorderseite angeordnet ist, woraus sich eine Verminderung des ersten Widerstandes ergibt, wobei die Tiefe der Ausnehmung in Abhängigkeit von dem gewünschten Wert dieses ersten Widerstandes gewählt ist.

4. Diode nach einem der Ansprüche 1 bis 3, dadurch gekennzeichnet, dass die die zwei lokalisierten Schichten voneinander trennende Zone mit einer Furche versehen ist (Fig. 14), woraus sich ergibt, dass der Wert des zweiten Widerstandes erhöht wird, wobei die Dimensionierung der Furche so gewählt ist, dass der Wert dieses zweiten Widerstandes eingestellt wird.

5. Diode nach einem der Ansprüche 1 bis 4, dadurch gekennzeichnet, dass die erste Metallisierung (24) auf der Vorderseite Kurzschlüsse zwischen der ersten lokalisierten Schicht und einer Zone zum Leitungstyp des Substrats gewährleistet (Fig. 15), woraus sich ergibt, dass ein Widerstand parallel zu der Diode eingeführt wird.

6. Montage eines Hauptleistungsschalter-Halbleiterbauelementes vom Darlington-Typ oder Thyristor-Typ mit Auslöseverstärkung und eines Hilfsbauteils (11, 44), das insbesondere die Funktion der Saugdiode erfüllt, in einem einzigen Bauteil, mit Druckmitteln zum Anlegen der einander gegenüberliegenden Metallisierungen der Vorderseiten des Hilfsbauteils und des Hauptbauteils aneinander dadurch gekennzeichnet, dass das Hilfsbauteil eine dreipolige Diode nach einem der Ansprüche 1 bis 5 ist.

7. Montage nach Anspruch 6, dadurch gekennzeichnet, dass weiche Leiterelemente wie Kugeln oder ein grobkörniges Pulver mit wenigstens einer der einander gegenüberliegenden Flächen der beiden Bauteile fest verbunden sind und den Kontakt zwischen den einander zugewandten Metallisierungen gewährleisten.

8. Montage nach Anspruch 6, dadurch gekennzeichnet, dass elastische Leiterelemente wie Ringfedern (201) zwischen wenigstens bestimmte der einander zugewandten Metallisierungen eingefügt sind.

9. Montage nach Anspruch 6, dadurch gekennzeichnet, dass leitfähige Zwischenelemente auf den Metallisierungen des Hauptelementes positioniert sind und mit den Metallisierungen des Hilfsbauteils in Kontakt kommen.

10. Montage nach Anspruch 6, wobei die Vorderseite des Leistungsschalterbauelements eine Hauptmetallisierung umfasst, welche den grössten Teil seiner Oberfläche einnimmt und auf welcher sich eine Hauptgegenelektrode abstützt, dadurch gekennzeichnet, dass die Druckmittel sich auf der genannten Hauptgegenelektrode abstützen.

11. Montage nach Anspruch 6, dadurch gekennzeichnet, dass die Druckmittel sich auf dem Gehäuse des Hauptbauteils abstützen.

12. Montage nach Anspruch 11, dadurch gekennzeichnet, dass die Druckmittel durch einen leitfähigen und elastischen Metallfinger gebildet sind, der an einem isolierten Teil des Gehäuses befestigt ist und mit einem Aussenanschluss am Gehäuse verbunden ist, sowie auf die Rückseite des Hilfsbauelements drückt.

13. Montage nach Anspruch 12, dadurch gekennzeichnet, dass der Metallfinger über einen leitfähigen Nagel der frei in einer isolierenden Führungsschale gleitet, auf das Hilfsbauelement drückt.

**Claims**

1. Three-terminal semiconductor diode comprising, in monolithic shape:
   — a substrate (20) of a first conductivity type,
   — on the front face of the substrate: a first localized layer (23) of the second conductivity type having a high doping level and a second localized layer (25) of the first conductivity type and having a high doping level, the surfaces accupied by each of these layers being substantially complementary, the first (24) and second (26) metallizations being respectively located on the first and second layers,
   characterized in that it further comprises on the back face of the substrate: a uniform layer (21) of the same conductivity type and having a high doping level, and covered by a metallization (22),
   whereby a first resistance is obtained between the metallization of the back face and the second metallization of the front face and a second resistance in series with a diode is obtained between the first and second metallizations of the front face.

2. Diode according to claim 1, characterized in that the first localized layer (23) is located at the periphery of the front face, the second localized layer (25) being located in central manner.

3. Diode according to claim 1 or 2, characterized in that the back face of the substrate is recessed (Fig. 13) prior to the forming of the highly doped layer on this face, substantially facing the second localized layer on the front face, resulting into a reduction of said first resistance, the depth of the recess being selected in dependence on the desired value of this first resistance.

4. Diode according to any of claims 1 to 3, characterized in that the zone separating the first and second localized layers is grooved (Fig. 14), whereby the value of the second resistance is increased, the dimension of the groove being selected to adjust the value of this second resistance.

5. Diode according to any of claims 1 to 4, characterized in that the first metallization (24) of the front face assures short-circuits between the first localized layer and a zone of the conductivity type of the substrate (Fig. 15), whereby a resistance is introduced in parallel with said diode.

6. Mounting of a semiconductor main power switching component (10, 40) of Darlington type or thyristor type with trigger amplification and of an auxiliary component (11, 44) assuring, in particular, the function of a destorage diode, comprising pressure means for urging one against another the facing metallizations of the front faces of the auxiliary and main components, characterized in that said auxiliary component is a three-terminal diode according to any of claims 1 to 5.

7. Mounting according to claim 6, characterized in that soft conductor members such as balls or a coarse grain powder are joined with at least one of the facing faces of the two components, assuring the contact between the facing metallizations.

8. Mounting according to claim 6, characterized in that resilient conductor members such as ring springs (201) are inserted between at least certain facing metallizations.

9. Mounting according to claim 6, characterized in that the inserted conductor members are positioned on metallizations of the main component for contacting the metallizations of the auxiliary component.

10. Mounting according to claim 6, in which the front face of the power switching component comprises a main metallization occupying the major portion of its surface, and against which a main counterelectrode is applied, characterized in that the pressure means urge against said main counterelectrode.

11. Mounting according to claim 6, characterized in that the pressure means urge against the housing of the main components.

12. Mounting according to claim 11, characterized in that the pressure means are composed of a metallic finger which is conductive and resilient and which is secured to an insulated portion of the housing and connected to an outer terminal of the housing, and which urges on the back face of the auxiliary component.

13. Mounting according to claim 12, characterized in that the metallic finger urges onto the auxiliary component through a conductive nail which is free to glide within an insulating gliding shell.

0 032 068

# FIG_1 "PRIOR ART"

$T_2$ · $T_1$ · A · B · C · D

# FIG_2

A · $TH_2$ · $TH_1$ · C · D · B

# FIG_3 "PRIOR ART"

D · C · D · B
6
2
3 · N · 5 · P · 5 · 3
1
N
4
N+
A

# FIG_4

B · D · C · D · B
N · 5 · P · 3 · 2
1
N
P · 7
A

# FIG_5 "PRIOR ART"

$T_2$ · A · C · D · $T_1$ · B · $D_S$

# FIG_6

A · $TH_2$ · D · $TH_1$ · C · B · $D_S$

9

# FIG_7

12     14     113     11     12     112     111     110     13     102     101     100     10

# FIG_8

14     15     12     11     10

# FIG_9

161     16     160     12     11     10

FIG_10-A

FIG_10-B

FIG_11

FIG_12

FIG_13

FIG_15

FIG_14

FIG_16

FIG_17

# FIG_18

# FIG_19

# FIG_20